# EUROPÄISCHE PATENTSCHRIFT

(11) **EP 3 577 253 B1**
(45) Veröffentlichungstag und Bekanntmachung des Hinweises auf die Patenterteilung: **09.09.2020**
(21) Anmeldenummer: 18707218.6
(22) Anmeldetag: 23.01.2018
(51) Int. Cl.: C23C 16/02, C23C 16/34, C23C 16/38, C23C 28/04, C23C 30/00

(54) **BESCHICHTETES WERKZEUG**
COATED TOOL
OUTIL REVÊTU

(30) Priorität: 31.01.2017 AT 2517 U
(43) Veröffentlichungstag der Anmeldung: 11.12.2019
(73) Patentinhaber: Ceratizit Austria Gesellschaft m.b.H., 6600 Reutte (AT)
(72) Erfinder: CZETTL, Christoph, 6600 Reutte (AT); THURNER, Josef, 6600 Reutte (AT); LECHLEITNER, Markus, 6600 Reutte (AT); JÄGER, Christian, 6600 Reutte (AT)
(74) Vertreter: Ciesla, Dirk
(86) Internationale Anmeldenummer: PCT/AT2018/000002
(87) Internationale Veröffentlichungsnummer: WO 2018/140990

(56) Entgegenhaltungen:
- EP-A1- 1 245 693
- EP-A1- 2 959 994
- WO-A1-2004/101455
- WO-A1-2009/070820
- AT-U1- 15 143
- DE-A1- 10 222 347
- FR-A1- 2 370 551

## Beschreibung

Die vorliegende Erfindung betrifft ein beschichtetes Werkzeug mit einem Substrat und einer auf dem Substrat abgeschiedenen Hartstoffbeschichtung, die unter anderem eine feinkörnige Titandiborid-Schicht aufweist.

Insbesondere bei einer zerspanenden Bearbeitung von metallischen Werkstoffen kommen neben unbeschichteten Werkzeugen aus z.B. Hartmetall oder Cermet bereits seit vielen Jahren auch beschichtete Werkzeuge zum Einsatz, bei denen auf dem ein Substrat bildenden Werkzeugkörper eine Hartstoffbeschichtung abgeschieden ist, um die Verschleißbeständigkeit und Zerspanungseigenschaften des Werkzeugs weiter zu verbessern. Das Werkzeug kann dabei z.B. einstückig aus dem Substratmaterial mit einem Schaft zur Verbindung mit einer Bearbeitungsmaschine ausgebildet sein, wie z.B. als sogenanntes Vollhartmetallwerkzeug, es kann insbesondere aber auch bevorzugt als ein auswechselbarer Schneideinsatz ausgebildet sein, der auswechselbar an einem Werkzeuggrundkörper befestigt werden kann.

Hartmetall und Cermet sind jeweils Verbundwerkstoffe, bei denen Hartstoffteilchen, die den überwiegenden Bestandteil des Verbundwerkstoffs bilden, in einen duktilen metallischen Binder eingebettet sind, der einen deutlich geringeren Anteil des Verbundwerkstoffs bildet. Zumindest in dem Fall eines hohen Anteils an Hartstoffteilchen hat der Verbundwerkstoff dabei eine aus den Hartstoffteilchen gebildete Skelett- oder Gerüst-Struktur, deren Zwischenräume durch den duktilen metallischen Binder gefüllt sind. Die Hartstoffteilchen können dabei insbesondere zumindest überwiegend durch Wolframkarbid, Titankarbid und/oder Titankarbonitrid gebildet sein, wobei in geringeren Mengen zusätzlich z.B. auch andere Hartstoffteilchen, insbesondere Karbide der Elemente der Gruppen IV bis VI des Periodensystems der Elemente, vorhanden sein können. Der duktile metallische Binder besteht üblicherweise zumindest überwiegend aus Cobalt, Nickel, Eisen oder einer Basislegierung von zumindest einem dieser Elemente. Es können allerdings in geringeren Mengen auch noch andere Elemente in dem metallischen Binder gelöst sein. Unter einer Basislegierung ist dabei zu verstehen, dass dieses Element den überwiegenden Bestandteil der Legierung bildet. Am häufigsten kommt Hartmetall zum Einsatz, bei dem die Hartstoffteilchen zumindest überwiegend durch Wolframkarbid gebildet sind und der metallische Binder eine Cobalt- oder Cobalt-Nickel-Basislegierung ist.

EP 2 209 929 B1 beschreibt ein Werkzeug für die spanabhebende Bearbeitung mit einem Substratmaterial und einer auf dem Substratmaterial abgeschiedenen Hartstoffbeschichtung, die eine durch ein thermisches CVD-Verfahren abgeschiedene Titandiborid-Schicht mit einem sehr feinkörnigen Gefüge aufweist.

WO 2004/101455 A1 beschreibt ein beschichtetes Werkzeug nach dem Oberbegriff von Anspruch 1.

In "Investigation of the origin of compressive residual stress in CVD TiB2 hard coatings using synchrotron X-ray nanodiffraction" von N. Schalk et al. in Surface and Coatings Technology, Vol. 258, 2014, S. 121-126, ist unter "Experimental methods" unter anderem beschrieben, wie Spannungszustände in Hartstoffbeschichtungen mittels Synchrotron-Untersuchungen bestimmt werden können.

Es ist Aufgabe der vorliegenden Erfindung, die Schichthaftung einer feinkörnigen Titandiborid-Schicht bei einem Werkzeug noch weiter zu verbessern und einen weiter verbesserten Betrieb eines beschichteten Werkzeugs zu ermöglichen.

Die Aufgabe wird durch ein beschichtetes Werkzeug nach Anspruch 1 gelöst. Vorteilhafte Weiterbildungen sind in den abhängigen Ansprüchen angegeben. Die Titanbordnitrid-Übergangsschicht mit einem in Richtung der Titandiborid-Schicht zunehmenden Borgehalt führt zu einer deutlichen Verbesserung der Schichthaftung der Hartstoffbeschichtung. Insbesondere wird ein sich nachteilig auswirkender starker Sprung in den Eigenspannungen in der Hartstoffbeschichtung an der Grenze zu der Titandiborid-Schicht vermieden. Da der Borgehalt in der Titanbornitrid-Übergangsschicht - auch nahe der Titandiborid-Schicht - einen Wert von 15 at.-% nicht übersteigt, wird dabei eine Bildung von Phasen mit hexagonaler Kristallstruktur, die sich negativ auf die Eigenschaften der Hartstoffbeschichtung auswirken würden, in der Titanbornitrid-Übergangsschicht zuverlässig vermieden. Es ist zu beachten, dass die Titannitrid-Schicht zwar eine exakt stöchiometrische Zusammensetzung aufweisen kann, dies aber nicht zwingend ist. Das Verhältnis zwischen Titan und Stickstoff in der Titannitrid-Schicht kann auch von dem stöchiometrischen Verhältnis abweichen, insbesondere kann die Titannitrid-Schicht eine Zusammensetzung TiNₓ mit 0,95 ≤ x ≤ 1,05 haben. Auch in der Titandiborid-Schicht kann eine leichte Abweichung von dem exakt stöchiometrischen Verhältnis vorliegen. In der Titanbornitrid-Übergangsschicht nimmt der Stickstoffgehalt mit zunehmendem Borgehalt, d.h. mit zunehmendem Abstand von der Titannitrid-Schicht, ab. Auch in dieser Schicht ist das Verhältnis zwischen Titan einerseits und Stickstoff/Bor andererseits aber nicht zwingend exakt stöchiometrisch, sondern kann auch leicht überstöchiometrisch oder unterstöchiometrisch sein. Der Borgehalt in den verschiedenen Bereichen der Titanbornitrid-Übergangsschicht kann z.B. mittels GDOES (Glow Discharge Optical Emission Spectroscopy) zuverlässig bestimmt werden. Bevorzugt nimmt der Borgehalt der Titanbornitrid-Schicht in Richtung der Titandiborid-Schicht auf zumindest 2, bevorzugt mindestens 5 at.-% zu. Es ist zu beachten, dass die Titandiborid-Schicht zwar die äußerste Schicht der Hartstoffbeschichtung bilden kann, es aber auch möglich ist, dass auf der Titandiborid-Schicht noch eine oder mehrere weitere Schichten abgeschieden sein können, z.B. insbesondere eine Titannitrid-Deckschicht.

Gemäß einer Weiterbildung weist die Titanbornitrid-Übergangsschicht eine Schichtdicke von 0,1-4,0 µm auf. In diesem Fall wird einerseits ein sehr guter Übergang der Spannungszustände in den verschiedenen Schichten der Hartstoffbeschichtung ermöglicht, der bei einer dünneren Schichtdicke nicht erreicht würde, und andererseits ist die Titanbornitrid-Übergangsschicht noch ausreichend dünn, sodass eine Verschlechterung der Hartstoffbeschichtung aufgrund einer zu großen Dicke zuverlässig vermieden wird. Die Titanbornitrid-Übergangsschicht kann bevorzugt eine Schichtdicke von 0,2-2,0 µm aufweisen.

Gemäß einer Weiterbildung nimmt der Borgehalt der Titanbornitrid-Übergangsschicht stufenartig zu. In diesem Fall kann die Zunahme des Borgehalts von der Titannitrid-Schicht in Richtung der Titandiborid-Schicht in prozesstechnisch besonders einfacher und zuverlässiger Weise eingestellt werden und dabei die Ausbildung hexagonaler Phasen in der Titanbornitrid-Übergangsschicht zuverlässig vermieden werden.

Gemäß einer Weiterbildung weist die Titannitrid-Schicht eine Schichtdicke von 0,1-2,0 µm auf. In diesem Fall wird eine besonders gute Anbindung der Hartstoffbeschichtung an dem Substrat erreicht und es kann insbesondere auch zuverlässig die Ausbildung einer borhaltigen Diffusionszone an der Oberfläche des Substrats verhindert werden. Bevorzugt kann die Titannitrid-Schicht eine Schichtdicke von 0,3-1,5 µm aufweisen.

Gemäß einer Weiterbildung weist die Titandiborid-Schicht eine Schichtdicke von 0,2-15,0 µm auf. Die Schichtdicke der Titandiborid-Schicht kann dabei in diesem Bereich vorteilhaft in Bezug auf das zu bearbeitende Material und die gewünschten Bearbeitungsbedingungen optimiert werden. Bevorzugt kann die Titandiborid-Schicht eine Schichtdicke von 1,0-10,0 µm aufweisen.

Gemäß einer Weiterbildung weist die Titandiborid-Schicht Druckeigenspannungen in einem Bereich von -2,5 ± 2 GPa auf, bevorzugt in einem Bereich von -2,5 ± 1 GPa. Die Bestimmung der Druckeigenspannungen in der Titandiborid-Schicht kann dabei in allgemein bekannter Weise röntgenographisch mittels des sin²ψ-Messverfahrens erfolgen, wie es in der eingangs zitierten Veröffentlichung von N. Schalk et al. in Surface and Coatings Technology, Vol. 258, 2014, S. 121-126 mit den dortigen weiteren Verweisungen beschrieben ist. Folgende Werte wurden für die Berechnung der Eigenspannungen verwendet: Elastizitätsmodul 565 GPa, Poissonzahl 0.108 (s. Journal of research of NIST vol 105 n°5 2000). In dem Fall, dass die Eigenspannungen der Titandiborid-Schicht in diesem Bereich liegen, wird eine besonders gute Beständigkeit der Hartstoffbeschichtung erreicht, die sich insbesondere besonders gut für eine zerspanende Bearbeitung von Titanlegierungen und anderen Nichteisenlegierungen eignet.

Gemäß einer Weiterbildung weist die Titandiborid-Schicht eine Härte von > 40 GPa auf. Die Härte der Titandiborid-Schicht kann dabei insbesondere bevorzugt in dem Bereich 40-50 GPa liegen. Die Härte kann dabei insbesondere mittels Nanoindentierung mit einem Berkovich-Eindringkörper aus Diamant zuverlässig bestimmt werden.

Gemäß einer Weiterbildung ist das beschichtete Werkzeug ein Zerspanungswerkzeug für Titanlegierungen und/oder andere Nichteisenlegierungen. In diesem Fall zeigt die erfindungsgemäße Hartstoffbeschichtung besonders deutliche Vorteile gegenüber herkömmlichen Beschichtungen. Bevorzugt kann das beschichtete Werkzeug als Zerspanungswerkzeug für Titanlegierungen ausgebildet sein.

Gemäß einer Weiterbildung ist das Substrat ein Hartmetall mit einer Hartstoffphase, die überwiegend aus Wolframkarbid besteht, und einer Binderphase, deren Hauptbestandteil in Gewichtsprozent Cobalt ist. In diesem Fall ist die Kombination aus Substrat und Hartstoffbeschichtung besonders gut für Zerspanungswerkzeuge geeignet. Das Substrat kann neben Wolframkarbid auch noch weitere, andere Hartstoffteilchen in geringeren Mengen aufweisen, insbesondere z.B. kubische Karbide von Elementen der Gruppen IV bis VI des Periodensystems der Elemente. Die Binderphase kann neben Cobalt auch noch weitere Bestandteile aufweisen, insbesondere also eine Cobalt-Basislegierung sein. Es können insbesondere neben Wolfram aus der Hartstoffphase z.B. auch noch Chrom, Molybdän, Ruthenium und weitere Metalle in der Binderphase vorliegen.

Gemäß einer Weiterbildung beträgt die Binderphase 5-17 Gew.-% des Hartmetalls. Die Menge der Binderphase kann dabei vorteilhaft auf das jeweils mit dem Werkzeug zu bearbeitende Material und die Bearbeitungsparameter abgestimmt werden.

Gemäß einer Weiterbildung weist die Binderphase einen Anteil von 6-16 Gew.-% der Binderphase Ruthenium auf. Insbesondere die Kombination eines Hartmetalls mit einer solchen Zusammensetzung als Substrat und der angegebenen Hartstoffbeschichtung hat sich als besonders geeignet für eine spanabhebende Bearbeitung von insbesondere Titanlegierungen erwiesen.

Gemäß einer Weiterbildung ist eine Grenzfläche des Substrats zu der Hartstoffbeschichtung hin frei von η-Phase und im Wesentlichen frei von Bor. Unter η-Phase werden im technischen Gebiet von Hartmetall (cemented carbide) komplexe Karbide von insbesondere Cobalt und Wolfram verstanden, die sich insbesondere unter stark kohlenstoffdefizitären Bedingungen ausbilden und zu einer unerwünschten Versprödung des Hartmetalls führen. Eine borhaltige Diffusionszone in dem Randbereich des Substrats würde sich ebenfalls negativ auf die Schichthaftung und folglich auf die Standzeit des beschichteten Werkzeugs auswirken.

Gemäß einer Weiterbildung ist auf der Titandiborid-Schicht eine Deckschicht ausgebildet. Die Ausbildung einer solchen Deckschicht kann insbesondere in vorteilhafter Weise eine vereinfachte Erkennung des Verschleißzustands des Werkzeugs ermöglichen. Bevorzugt kann die Deckschicht dabei ein Karbid, Nitrid, Oxid, Karbonitrid, Oxynitrid oder Karbooxynitrid von zumindest einem der Elemente Ti, Zr, Hf sein, sodass die Eigenschaften des beschichteten Werkzeugs nicht nachteilig beeinflusst werden.

Gemäß einer Weiterbildung weist die Titanbornitrid-Übergangsschicht durchgehend eine kubische Kristallstruktur auf. In diesem Fall ist eine Verschlechterung der Schichthaftung, die von hexagonalen Phasenanteilen in der Titanbornitrid-Übergangsschicht ausgehen würde, zuverlässig verhindert. Die durchgehende kubische Kristallstruktur kann z.B. mittels TEM-Untersuchungen (Transmissions-Elektronen-Mikroskop) zuverlässig nachgewiesen werden, wobei eine örtlich besonders fein aufgelöste Untersuchung z.B. auch mittels Synchrotron-Messungen erfolgen kann. Die geeignete Durchführung solcher Synchrotron-Messungen ist z.B. in "X-ray nanodiffraction reveals strain and microstructure evolution in nanocrystalline thin films" von J. Keckes et al. in Scripta Materialia 67 (2012) 748-751 beschrieben.

Gemäß einer Weiterbildung weist die Titandiborid-Schicht ein feinkörniges Gefüge mit einer mittleren Kristallitgröße von kleiner 50 nm auf. Die Ermittlung einer solchen Feinkörnigkeit kann insbesondere mit einem Röntgen-Diffraktometer vom Typ Bruker D8 Advance im locked-coupled Modus mit Kupfer-Kα-Strahlung in einem θ-2θ -Scan in Parallelstrahlgeometrie mit 0,02°Schrittweite und 1,2 Sekunden Countingtime über einen Winkelbereich von 20° - 80° erfolgen. Wie dem Fachmann allgemein bekannt ist, korreliert die Halbwertsbreite der deutlich messbaren Reflexe mit der mittleren Kristallitgröße. Für die Bestimmung der Feinkörnigkeit der Titandiborid-Schicht mit einer mittleren Kristallitgröße von kleiner 50 nm ist die Halbwertsbreite (FWHM) des (101)-Reflexes von Titandiborid nach Korrektur der instrumentellen Verbreiterung heranzuziehen, die mindestens 0,5° betragen muss, bevorzugt in einem Bereich von 0,5°-2° liegt. Die Bestimmung der mittleren Kristallitgröße anhand der Halbwertsbreite ist in "The "state of the art" of the diffraction analysis of crystallite size and lattice strain" von E. Mittemeijer et al. in Z. Kristallogr. 223 (2008) 552-560 ausführlich beschrieben. Hierfür können kommerzielle Softwarepakete verwendet werden, wie im angeführten Beispiel die Software Topas 4.2 der Firma Bruker. Diese extreme Feinkörnigkeit führt zu einer besonders glatten Oberfläche der Titandiborid-Schicht, sodass es auch bei der Bearbeitung von schwer zerspanbaren Werkstoffen, wie insbesondere Titanlegierungen, kaum zu Verklebungen von ablaufenden Spänen an der Oberfläche kommt.

Gemäß einer Weiterbildung ist die Hartstoffbeschichtung durch ein thermisches CVD-Verfahren abgeschieden. Die Beschichtung kann dabei insbesondere typischerweise bei Temperaturen zwischen ca. 850°C und ca. 1050°C abgeschieden werden. Die höheren Temperaturen, die bei einem thermischen CVD-Verfahren (chemical vapor deposition) zum Einsatz kommen, haben gegenüber z.B. einer Abscheidung in einem bei niedrigeren Temperaturen arbeitenden PA-CVD (plasma-assisted CVD) den Vorteil einer wesentlich besseren resultierenden Schichthaftung.

Die Aufgabe wird auch durch die Verwendung des beschichteten Werkzeugs für eine spanabhebende Bearbeitung von Titanlegierungen und/oder anderen Nichteisenlegierungen gemäß Anspruch 16 gelöst.

Weitere Vorteile und Zweckmäßigkeiten der Erfindung ergeben sich anhand der nachfolgenden Beschreibung von Ausführungsbeispielen unter Bezugnahme auf die beigefügten Figuren.

Von den Figuren zeigen:
- Fig. 1:: ein metallographisches Schliffbild eines beschichteten Werkzeugs mit einer auf einem Substrat abgeschiedenen Hartstoffbeschichtung gemäß einem Vergleichsbeispiel;
- Fig. 2:: ein metallographisches Kalotten-Schliffbild des beschichteten Werkzeugs aus Fig. 1;
- Fig. 3:: ein metallographisches Schliffbild eines beschichteten Werkzeugs gemäß einer Ausführungsform;
- Fig. 4:: ein metallographisches Kalotten-Schliffbild des beschichteten Werkzeugs gemäß der Ausführungsform, und
- Fig. 5:: ein XRD-Diffraktogramm des beschichteten Werkzeugs gemäß der Ausführungsform.

### AUSFÜHRUNGSFORM

Eine Ausführungsform wird im Folgenden unter Bezugnahme auf die beiliegenden Figuren eingehender erläutert.

Das beschichtete Werkzeug 1 gemäß der Ausführungsform ist als ein Zerspanungswerkzeug für die spanabhebende Bearbeitung von Werkstoffen ausgelegt, insbesondere von Titanlegierungen und/oder anderen Nichteisenlegierungen. Bei dem konkret folgenden Beispiel ist das beschichtete Werkzeug dabei in Form eines auswechselbaren Schneideinsatzes ausgebildet, der an einem Werkzeuggrundkörper auswechselbar befestigt werden kann. Es ist jedoch z.B. auch möglich, das beschichtete Werkzeug einstückig mit einem Einspannabschnitt zur Verbindung mit einer Werkzeugaufnahme auszubilden, insbesondere z.B. als ein sogenanntes Vollhartmetallwerkzeug.

Das beschichtete Werkzeug 1 weist ein Substrat 2 und eine auf dem Substrat 2 abgeschiedene mehrlagige Hartstoffbeschichtung 3 auf. Bei dem konkret dargestellten Beispiel ist das Substrat 2 ein Hartmetall mit einer überwiegend durch Wolframkarbid gebildeten Hartstoffphase 4 und einer Binderphase 5, deren Hauptbestandteil Cobalt ist. Die Binderphase 5 ist in dem konkreten Beispiel eine Cobalt-Basislegierung, die einen Anteil von 5-17 Gew.-% des Substrats 2 ausmacht. In einer besonders bevorzugten Ausgestaltung ist die Binderphase 5 eine Cobalt-Basislegierung, die neben Cobalt zumindest auch einen Anteil von 6-16 Gew.-% der Binderphase Ruthenium aufweist.

Die Hartstoffbeschichtung 3 weist einen mehrlagigen Aufbau auf, bei dem unmittelbar auf dem Substrat 2 eine Titannitrid-Schicht 3a ausgebildet ist, die eine Schichtdicke im Bereich von 0,1-2,0 µm aufweist, wobei eine Schichtdicke im Bereich von 0,3-1,5 µm bevorzugt ist. Die Titannitrid-Schicht 3a weist in an sich bekannter Weise eine kubische Kristallstruktur auf. Die Grenzfläche des Substrats 2 zu der Hartstoffbeschichtung 3 hin ist frei von η-Phase und im Wesentlichen frei von Bor.

Auf der Titannitrid-Schicht 3a ist eine Titanbornitrid-Übergangsschicht 3b ausgebildet, deren Borgehalt mit zunehmendem Abstand von der Titannitrid-Schicht 3a zunimmt und deren Stickstoffgehalt entsprechend mit zunehmendem Abstand von der Titannitrid-Schicht 3a abnimmt. Die Titanbornitrid-Übergangsschicht 3b hat eine Schichtdicke von 0,1-4,0 µm, wobei die Schichtdicke bevorzugt 0,2-2,0 µm betragen kann. Bei dem konkreten Ausführungsbeispiel steigt der Borgehalt in der Titanbornitrid-Übergangsschicht 3b dabei in mehreren Stufen mit zunehmendem Abstand von der Titannitrid-Schicht 3a stufenartig an. Dieser stufenartige Anstieg des Borgehalts in der Titanbornitrid-Übergangsschicht 3b kann in einfacher Weise bei der Abscheidung der Titanbornitrid-Übergangsschicht 3b durch eine Veränderung der Prozessgasatmosphäre bei einem thermischen CVD-Verfahren realisiert werden, wie noch eingehender beschrieben wird. Die Titanbornitrid-Übergangsschicht 3b weist in einem unmittelbar an die Titannitrid-Schicht 3a angrenzenden Bereich einen sehr niedrigen Borgehalt auf, der bei der Ausführungsform deutlich weniger als 5 at.-% beträgt. Wie bereits erläutert, steigt der Borgehalt in der Titanbornitrid-Übergangsschicht 3b mit zunehmendem Abstand von der Titannitrid-Schicht 3a an, übersteigt aber nicht einen Borgehalt von 15 at.-% in dem am weitesten von der Titannitrid-Schicht 3a entfernten Bereich. Neben dem besonders bevorzugten stufenartigen Anstieg des Borgehalts, der über eine Mehrzahl von Stufen, z.B. zwischen zwei und 16 Stufen erfolgen kann, ist es z.B. auch möglich, einen im Wesentlichen kontinuierlichen Anstieg des Borgehalts in der Titanbornitrid-Übergangsschicht 3b vorzusehen. Auch in diesem Fall darf der Borgehalt in der Titanbornitrid-Übergangsschicht 3b in dem am weitesten von der Titannitrid-Schicht 3a entfernten Bereich jedoch 15 at.-% nicht übersteigen, um die Ausbildung von hexagonalen Phasen in der Titanbornitrid-Übergangsschicht 3b zuverlässig zu vermeiden. Die Titanbornitrid-Übergangsschicht 3b (d.h. die Kristallite der polykristallinen Titanbornitrid-Übergangsschicht 3b) weist somit durchgehend eine kubische Kristallstruktur auf und ist frei von hexagonalen Phasenanteilen, wie mittels TEM-Messungen und Synchrotron-Messungen nachgewiesen werden kann. Die Titanbornitrid-Übergangsschicht 3b weist über ihre gesamte Dicke eine - mittels Nanoindentierung mit einem Berkovich-Prüfkörper aus Diamant gemessene - Härte im Bereich 20-35 GPa auf. Die Härtemessung erfolgt dabei mit einem Nanoindenter der mit einem Berkovich-Prüfkörper aus Diamant ausgestattet ist. Zur Messung wird eine Maximallast von 5 mN verwendet. Als Messgerät diente im Ausführungsbeispiel ein Hysitron Triboindenter TI950.

Auf der von der Titannitrid-Schicht 3a abgewandten Seite der Titanbornitrid-Übergangsschicht 3b ist eine extrem feinkörnige Titandiborid-Schicht 3c ausgebildet, die eine mittlere Kristallitgröße von kleiner 50 nm aufweist. Die Titandiborid-Schicht 3c hat eine Schichtdicke im Bereich von 0,2-15,0 µm. Die Titandiborid-Schicht 3c kann dabei bevorzugt eine Schichtdicke im Bereich von 1,0-10,0 µm aufweisen. Wie auch bei Titannitrid-Schicht 3a und der Titanbornitrid-Übergangsschicht 3b kann die Schichtdicke der Titandiborid-Schicht 3c bei der Abscheidung in einem thermischen CVD-Verfahren insbesondere über die jeweilige Beschichtungsdauer gesteuert werden, wobei die Schichten in an sich bekannter Weise in ihrer Dicke leicht variieren können, z.B. in Abhängigkeit von der Position in dem für die Beschichtung verwendeten CVD-Reaktor, etc. Die Titandiborid-Schicht 3c weist aufgrund ihrer sehr feinkörnigen Gestalt und der Abscheidungsbedingungen in einem thermischen CVD-Verfahren bei Temperaturen in einem Bereich zwischen 850°C und 1050°C Druckeigenspannungen in einem Bereich von -2,5 ± 2 GPa auf, bevorzugt von -2,5 ± 1 GPa, die in bekannter Weise röntgenographisch mittels des sin²ψ-Messverfahrens bestimmt werden können. Die Titandiborid-Schicht 3c weist eine - wiederum mittels Nanoindentierung mit einem Berkovich-Prüfkörper aus Diamant wie oben beschrieben gemessene - Härte von mehr als 40 GPa, insbesondere im Bereich 40-50 GPa auf. Die Härte der Titandiborid-Schicht 3c ist somit insbesondere deutlich höher als die Härte von ca. 38 GPa, die Titandiborid-Bulkmaterial aufweist.

Aufgrund der Beschränkung des Borgehalts in der Titanbornitrid-Übergangsschicht 3b, die die Ausbildung von Kristalliten mit hexagonaler Kristallstruktur in der Titanbornitrid-Übergangsschicht 3b, verhindert, liegt in der Hartstoffbeschichtung 3 an dem Übergang von der Titanbornitrid-Übergangsschicht 3b zu der Titandiborid-Schicht 3c ein Sprung im Borgehalt vor (von einem Borgehalt von maximal 15 at.-% in der Titanbornitrid-Übergangsschicht 3b auf einen Borgehalt von ca. 66 at.-% in der Titandiborid-Schicht 3c). Aufgrund dieses sprunghaften Anstiegs an dem Übergang, ist der Übergang von der Titanbornitrid-Übergangsschicht 3b auf die Titandiborid-Schicht 3c auch in einem metallographischen Kalotten-Schliffbild, bei dem die Hartstoffbeschichtung 3 schräg angeschliffen wird, als Grenzfläche erkennbar.

Die Abscheidung der Hartstoffbeschichtung 3 auf dem Substrat 2 erfolgte bei der Ausführungsform in einem handelsüblichen thermischen CVD-Reaktor im Produktionsmaßstab bei Abscheidungstemperaturen im Temperaturfenster von 860°C bis 920°C.

Zunächst wurde auf dem Substrat 2 die Titannitrid-Schicht 3a in an sich bekannter Weise in einem thermischen CVD-Verfahren mit der gewünschten Schichtdicke im Bereich von 0,3-1,5 µm abgeschieden, wobei die Schichtdicke über die Beschichtungsdauer gesteuert wurde. Die Beschichtungsparameter, die bei dem nachfolgenden Beispiel mit einer beispielhaft vierstufigen Titanbornitrid-Übergangsschicht 3b mit den Stufen 3b.1, 3b.2, 3b.3 und 3b.4 verwendet wurden, sind der nachfolgenden Tabelle zu entnehmen: Die Angaben entsprechen den Mengen (in Vol.-%) des Precursors in gasförmigem Zustand. Die verwendeten Temperaturen und Prozessdrücke sind ebenfalls in der Tabelle 1 angegeben. Der Gesamtgasfluss und die Beschichtungszeit muss in bekannter Weise an die Bauart der Beschichtungsanlage angepasst werden, um die gewünschten Schichtdicken zu erreichen.

**Tabelle 1**

| | H₂[%] | Ar[%] | N₂[%] | BCl₃[%] | TiCl₄[%] | T[°C] | P [mbar] |
|---|---|---|---|---|---|---|---|
| TiN (3a) | Rest | - | 44 | 0 | 2 | 920 | 900 |
| TiNB_1 (3b.1) | Rest | - | 44 | 0,08 | 1,27 | 880 | 900 |
| TiNB_2 (3b.2) | Rest | - | 44 | 0,13 | 1,27 | 880 | 900 |
| TiNB_3 (3b.3) | Rest | - | 44 | 0,17 | 1,27 | 880 | 900 |
| TiNB_4 (3b.4) | Rest | - | 44 | 0,21 | 1,27 | 880 | 900 |
| TiB₂ (3c) | Rest | 80 | - | 1,62 | 0,80 | 860 | 900 |

Die Titanbornitrid-Übergangsschicht 3b wurde mit einer stufenartigen Zunahme des Borgehalts auf der zuvor abgeschiedenen Titannitrid-Schicht 3a abgeschieden. Um die stufenartige Zunahme des Borgehaltes in der Titanbornitrid-Übergangsschicht 3b zu realisieren, wurde dabei die Durchflussmenge von BCl₃ in dem Reaktor stufenweise erhöht, in einer konkreten Ausgestaltung von zunächst 0,08 Vol.-%, über 0,13 Vol.-% BCl₃ und 0,17 Vol.-% BCl₃ bis auf einen Maximalwert von 0,21 Vol.-% BCl₃, mit dem ein Borgehalt in dem äußersten Bereich der Titanbornitrid-Übergangsschicht 3b von ca. 14 at.-% erzielt wurde.

Um den erforderlichen Borgehalt in der Titanbornitrid-Übergangsschicht 3b zu bestimmen, mit dem ein guter Spannungsübergang erreicht werden kann, aber noch keine hexagonalen Phasenanteile in der Titanbornitrid-Übergangsschicht 3b auftreten, wurden Vorversuche mit einer stufenartigen Erhöhung der Zufuhr von BCl₃ in dem Reaktor durchgeführt, bei denen die Mengen an BCl₃ bis auf deutlich höhere Werte erhöht wurden und anschließend die erreichten Borgehalte in at.-% in den jeweiligen Bereichen der derart erzeugten Titanbornitrid-Schicht mittels GDOES-Tiefenprofilmessungen ermittelt wurden. Ferner wurden die jeweiligen Bereiche der derart erzeugten Titanbornitrid-Schicht mittels TEM-Untersuchungen und SAED (selected area electron diffraction) auf die Anwesenheit von hexagonalen Phasenanteilen untersucht. Bei diesen Untersuchungen wurde festgestellt, dass ab einem Bor-Gehalt oberhalb von 15 at.-% in der Titanbornitrid-Schicht hexagonale Phasenanteile auftraten, die sich nachteilig auf die Härte und die Schichthaftung der Hartstoffbeschichtung auswirkten.

### BEISPIEL

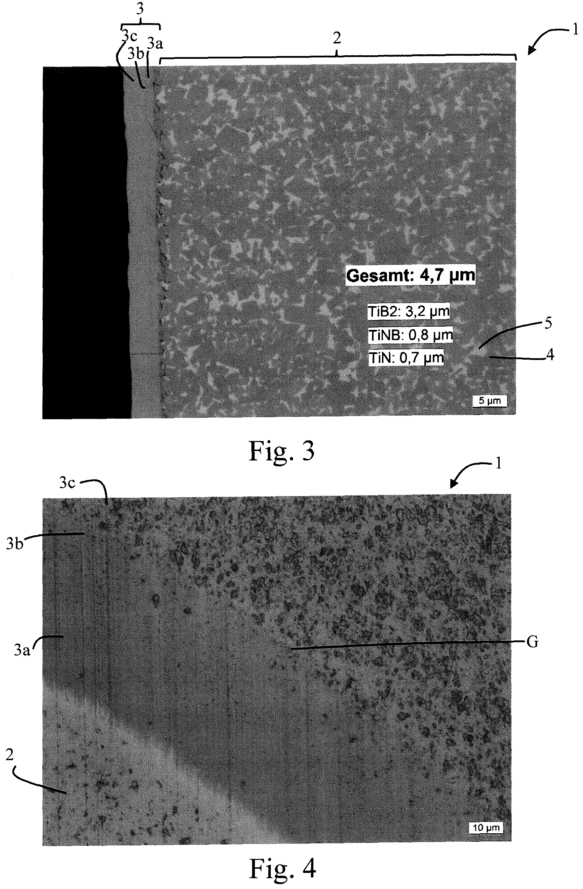

Um ein beschichtetes Werkzeug 1 zu erzeugen wurde ein auswechselbarer Schneideinsatz für die Zerspanung von Titanlegierungen mit der erfindungsgemäßen Hartstoffbeschichtung 3 beschichtet, wie anhand der Fig. 3 und Fig. 4 eingehender beschrieben wird. Der als Substrat 2 dienende Schneideinsatz bestand aus einem handelsüblichen Hartmetall der Anmelderin mit einer Zusammensetzung von 10 Gew.-% Cobalt, 1,5 Gew.-% Ruthenium, Rest Wolframkarbid und einer mittleren Korngröße der Wolframkarbidkörner zwischen 1,3-2,5 µm.

Auf diesem Substrat 2 wurde zunächst eine Titannitrid-Schicht 3a mit einer Schichtstärke von 0,7 µm abgeschieden.

Auf dieser Titannitrid-Schicht 3a wurde anschließend bei ca. 880°C eine ca. 0,8 µm dicke Titanbornitrid-Übergangsschicht 3b mit einem mit zunehmendem Abstand von der Titannitrid-Schicht 3a stufenartig zunehmendem Borgehalt abgeschieden. Der Borgehalt in der Titanbornitrid-Übergangsschicht 3b wurde dabei durch eine stufenartige Veränderung der Flussmenge an BCl₃ in dem Reaktor von 0,08 Vol.-%, über 0,13 Vol.-% und 0,17 Vol.-% bis auf 0,21 Vol.-% eingestellt, wodurch eine Titanbornitrid-Übergangsschicht 3b mit über vier Stufen variierendem Borgehalt erzielt wurde. Die jeweilige Beschichtungsdauer wurde dabei derart gewählt, dass die vier Stufen der Titanbornitrid-Übergangsschicht 3b jeweils mit etwa 0,2 µm im Wesentlichen gleich dick waren. Die Titanbornitrid-Übergangsschicht 3b wies eine über ihre Dicke leicht variierende Härte zwischen 20 GPa und 35 GPa auf.

Auf die Titanbornitrid-Übergangsschicht 3b wurde anschließend eine sehr feinkörnige Titandiborid-Schicht 3c mit einer Schichtdicke von ca. 3,2 µm abgeschieden. Ein lichtmikroskopisches Schliffbild mit 1000-facher Vergrößerung des beschichteten Werkzeugs 1 ist in Fig. 3 zu sehen. Der Borgehalt der Titanbornitrid-Übergangsschicht 3b betrug in den jeweiligen Stufen ca. 4 at.-%, ca. 8 at.-%, ca. 11 at.-% und in der äußersten Stufe ca. 14 at.-%, wie anhand von GDOES-Messungen ermittelt wurde. Ferner war die Randzone des Substrats 2 zu der Hartstoffbeschichtung 3 hin frei von η-Phase und im Wesentlichen frei von Bor.

Wie ebenfalls nach Fertigstellung des beschichteten Werkzeugs 1 mittels TEM-Messungen und Synchrotron-Messungen eingehend untersucht wurde, war die Titanbornitrid-Übergangsschicht 3b frei von hexagonalen Phasenanteilen und es konnten nur kubische Phasenanteile festgestellt werden. Die Eigenspannungen in der Titandiborid-Schicht 3c wurden mittels des sin²ψ-Messverfahrens bestimmt und betrugen bei dem Beispiel -2026±130 MPa. Die Härte der Titandiborid-Schicht 3c betrug 44 GPa.

Ein Kalotten-Schliffbild des beschichteten Werkzeugs 1 gemäß dem Beispiel ist in Fig. 4 zu sehen. Es ist zu erkennen, dass die Schichthaftung sehr gut und die Hartstoffbeschichtung insgesamt sehr gleichmäßig ist.

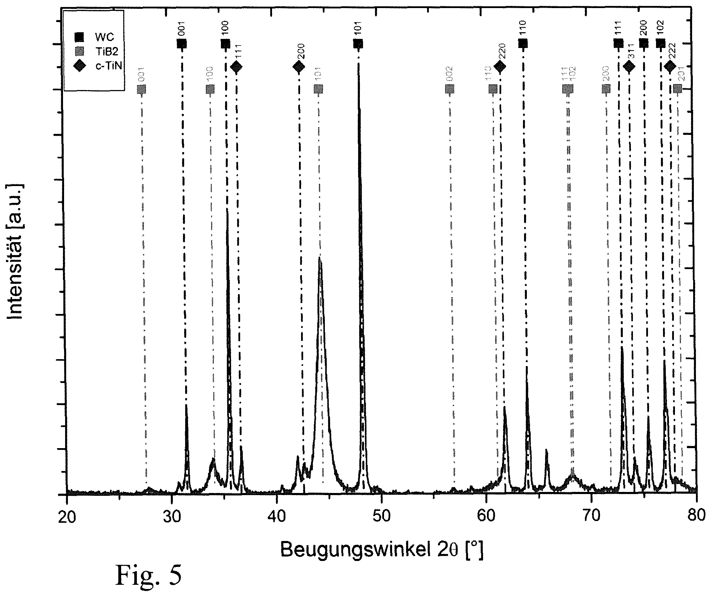

Ein XRD (x-ray diffraction)-Diffraktogramm des beschichteten Werkzeugs 1 gemäß dem Beispiel ist in Fig. 5 zu sehen. Die Messung erfolgte mit einem Röntgen-Diffraktometer vom Typ Bruker D8 Advance im locked-coupled Modus mit Kupfer-Kα-Strahlung in einem θ-2θ -Scan in Parallelstrahlgeometrie mit 0,02°Schrittweite und 1,2 Sekunden Countingtime über einen Winkelbereich von 20° - 80°. Die Titanborid-Schicht 3c weist ein sehr feinkörniges Gefüge mit einer mittleren Kristallitgröße von deutlich unter 50 nm auf. Die Halbwertsbreite (FWHM) des (101)-Reflexes von Titandiborid betrug nach Rietveld refinement 0,8421°.

### VERGLEICHSBEISPIEL

Als Vergleichsbeispiel wurde ein beschichtetes Werkzeug 101 hergestellt, bei dem ein dem zuvor beschriebenen Beispiel entsprechendes Hartmetall-Substrat 102 (Wolframkarbid, 10 Gew.-% Cobalt, 1,5 Gew.-% Ruthenium; mittlere Korngröße des Wolframkarbids von 1,3-2,5 µm) mit einer bekannten Hartstoffbeschichtung 103 beschichtet wurde.

Auf dem Substrat 102 wurde in gleicher Weise wie bei dem zuvor beschriebenen Beispiel zunächst eine Titannitrid-Schicht 103a ausgebildet, mit einer Schichtdicke von ca. 1,2 µm. Anschließend wurde unmittelbar auf dieser Titannitrid-Schicht 103 eine feinkörnige Titandiborid-Schicht 103c mit einer Schichtdicke von ca. 3,3 µm abgeschieden.

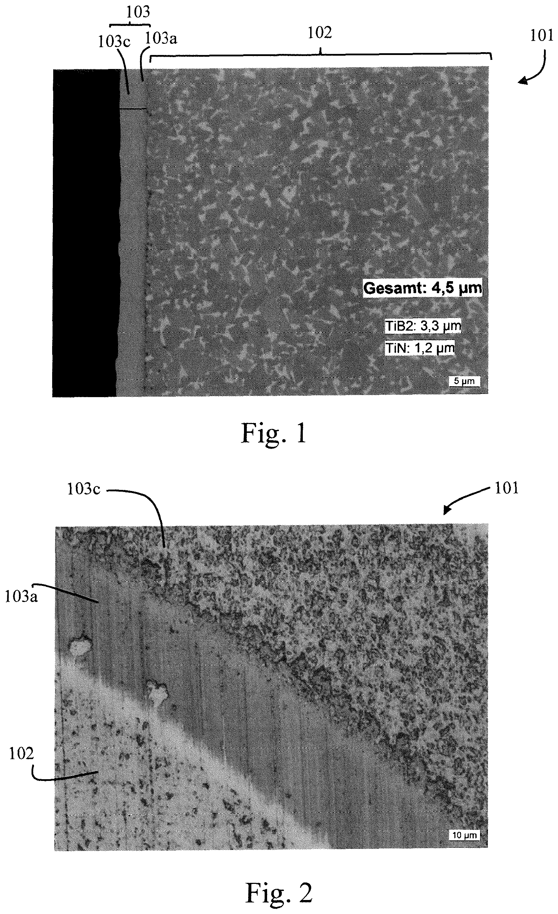

Ein lichtmikroskopisches Schliffbild mit 1000-facher Vergrößerung des beschichteten Werkzeugs 101 gemäß diesem Vergleichsbeispiel ist in Fig. 1 zu sehen. Wie aus dem Kalotten-Schliffbild des beschichteten Werkzeugs 101 gemäß dem Vergleichsbeispiel in Fig. 2 zu sehen ist, ist der Schichtaufbau der Hartstoffbeschichtung 103 bei dem Vergleichsbeispiel wesentlich ungleichmäßiger. Wie aus einzelnen bei dem Anfertigen des Kalotten-Schliffbildes entstandenen Abplatzungen zu sehen ist, ist die Schichthaftung der Hartstoffbeschichtung 103 bei dem Vergleichsbeispiel auch deutlich geringer als die Schichthaftung der Hartstoffbeschichtung 3 bei dem zuvor beschriebenen Beispiel.

### WEITERBILDUNGEN

Sofern dies z.B. gewünscht ist, um eine verbesserte Erkennung des Verschleißzustands der Hartstoffbeschichtung 3 zu ermöglichen, kann auf der Titandiborid-Schicht 3c auch noch eine zusätzliche Deckschicht ausgebildet werden. Die Deckschicht kann dabei insbesondere ein Karbid, Nitrid, Oxid, Karbonitrid, Oxynitrid oder Karbooxynitrid von zumindest einem der Elemente Ti, Zr, Hf sein.

## Patentansprüche

1. Beschichtetes Werkzeug (1) mit:
einem Substrat (2) und
einer auf dem Substrat (2) abgeschiedenen Hartstoffbeschichtung (3), wobei die Hartstoffbeschichtung (3) ausgehend von dem Substrat (2) einen Schichtaufbau in der folgenden Reihenfolge aufweist mit:
einer Titannitrid-Schicht (3a),
einer Titanbornitrid-Übergangsschicht (3b), und
einer Titandiborid-Schicht (3c);
wobei die Titanbornitrid-Übergangsschicht (3b) einen von der Titannitrid-Schicht (3a) in Richtung der Titandiborid-Schicht (3c) zunehmenden Borgehalt aufweist,
**dadurch gekennzeichnet, dass** der Borgehalt der Titanbornitrid-Übergangsschicht (3b) 15 at.-% nicht übersteigt.

2. Beschichtetes Werkzeug nach Anspruch 1, wobei die Titanbornitrid-Übergangsschicht (3b) eine Schichtdicke von 0,1-4,0 µm aufweist, bevorzugt von 0,2-2,0 µm.

3. Beschichtetes Werkzeug nach Anspruch 1 oder 2, wobei der Borgehalt der Titanbornitrid-Übergangsschicht (3b) stufenartig zunimmt.

4. Beschichtetes Werkzeug nach einem der vorangehenden Ansprüche, wobei die Titannitrid-Schicht (3a) eine Schichtdicke von 0,1-2,0 µm aufweist, bevorzugt von 0,3-1,5 µm.

5. Beschichtetes Werkzeug nach einem der vorangehenden Ansprüche, wobei die Titandiborid-Schicht (3c) eine Schichtdicke von 0,2-15,0 µm aufweist, bevorzugt von 1,0-10,0 µm.

6. Beschichtetes Werkzeug (1) nach einem der vorangehenden Ansprüche, wobei die Titandiborid-Schicht (3c) Druckeigenspannungen in einem Bereich von -2,5 ± 2 GPa aufweist.

7. Beschichtetes Werkzeug nach einem der vorangehenden Ansprüche, wobei die Titandiborid-Schicht (3c) eine Härte von zumindest 40 GPa aufweist.

8. Beschichtetes Werkzeug nach einem der vorangehenden Ansprüche, wobei das beschichtete Werkzeug (1) ein Zerspanungswerkzeug für Titanlegierungen und/oder andere Nichteisenlegierungen ist.

9. Beschichtetes Werkzeug nach einem der vorangehenden Ansprüche, wobei das Substrat (2) ein Hartmetall ist mit einer Hartstoffphase (4), die überwiegend aus Wolframkarbid besteht, und einer Binderphase (5), deren Hauptbestandteil Cobalt ist.

10. Beschichtetes Werkzeug nach Anspruch 9, wobei die Binderphase (5) 5-17 Gew.-% des Hartmetalls beträgt.

11. Beschichtetes Werkzeug nach Anspruch 9 oder 10, wobei die Binderphase (5) einen Anteil von 6-16 Gew.-% der Binderphase Ruthenium aufweist.

12. Beschichtetes Werkzeug nach einem der vorangehenden Ansprüche, wobei eine Grenzfläche des Substrats (2) zu der Hartstoffbeschichtung (3) hin frei von η-Phase und im Wesentlichen frei von Bor ist.

13. Beschichtetes Werkzeug nach einem der vorangehenden Ansprüche, wobei auf der Titandiborid-Schicht (3c) eine Deckschicht ausgebildet ist.

14. Beschichtetes Werkzeug nach einem der vorangehenden Ansprüche, wobei die Titanbornitrid-Übergangsschicht (3b) durchgehend eine kubische Kristallstruktur aufweist

15. Beschichtetes Werkzeug nach einem der vorangehenden Ansprüche, wobei die Titandiborid-Schicht (3c) ein feinkörniges Gefüge mit einer mittleren Kristallitgröße von kleiner 50 nm aufweist.

16. Verwendung eines beschichteten Werkzeugs (1) nach einem der vorangehenden Ansprüche für eine spanabhebende Bearbeitung von Titanlegierungen und/oder anderen Nichteisenlegierungen.

## Claims

1. A coated tool (1) comprising:
a substrate (2) and
a hard material coating (3) deposited on the substrate (2),
wherein the hard material coating (3) has, starting from the substrate (2), a layer structure comprising, in the following order:
a titanium nitride layer (3a),
a titanium boronitride transition layer (3b) and
a titanium diboride layer (3c);
where the titanium boronitride transition layer (3b) has a boron content which increases from the titanium nitride layer (3a) in the direction of the titanium diboride layer (3c),
**characterized in that** the boron content of the titanium boronitride transition layer (3b) does not exceed 15 at.-%.

2. The coated tool as claimed in claim 1, wherein the titanium boronitride transition layer (3b) has a layer thickness of 0.1-4.0 µm, preferably 0.2-2.0 µm.

3. The coated tool as claimed in claim 1 or 2, wherein the boron content of the titanium boronitride transition layer (3b) increases in steps.

4. The coated tool as claimed in any of the preceding claims, wherein the titanium nitride layer (3a) has a layer thickness of 0.1-2.0 µm, preferably 0.3-1.5 µm.

5. The coated tool as claimed in any of the preceding claims, wherein the titanium diboride layer (3c) has a layer thickness of 0.2-15.0 µm, preferably 1.0-10.0 µm.

6. The coated tool (1) as claimed in any of the preceding claims, wherein the titanium diboride layer (3c) has compressive residual stresses in the range -2.5 ± 2 GPa.

7. The coated tool as claimed in any of the preceding claims, wherein the titanium diboride layer (3c) has a hardness of at least 40 GPa.

8. The coated tool as claimed in any of the preceding claims, wherein the coated tool (1) is a cutting machining tool for titanium alloys and/or other nonferrous alloys.

9. The coated tool as claimed in any of the preceding claims, wherein the substrate (2) is a cemented hard material comprising a hard material phase (4) which consists predominantly of tungsten carbide and a binder phase (5) whose main constituent is cobalt.

10. The coated tool as claimed in claim 9, wherein the binder phase (5) makes up 5-17% by weight of the cemented hard material.

11. The coated tool as claimed in claim 9 or 10, wherein the binder phase (5) comprises ruthenium in a proportion of 6-16% by weight of the binder phase.

12. The coated tool as claimed in any of the preceding claims, wherein an interface of the substrate (2) to the hard material coating (3) is free of η phase and is substantially free of boron.

13. The coated tool as claimed in any of the preceding claims, wherein a covering layer is formed on the titanium diboride layer (3c).

14. The coated tool as claimed in any of the preceding claims, wherein the titanium boronitride transition layer (3b) has a cubic crystal structure throughout.

15. The coated tool as claimed in any of the preceding claims, wherein the titanium diboride layer (3c) has a fine-grained microstructure having an average crystallite size of less than 50 nm.

16. The use of a coated tool (1) as claimed in any of the preceding claims for cutting machining of titanium alloys and/or other nonferrous alloys.

## Revendications

1. Outil revêtu (1) présentant :
- un substrat (2) et
- un revêtement de matériau dur (3) déposé sur le substrat (2),
le revêtement de matériau dur (3) présentant, partant du substrat (2) une structure à couches dans l'ordre suivant :
- une couche de nitrure de titane (3a),
- une couche de transition à base de nitrure de bore et de titane (3b) et
- une couche de diborure de titane (3c) ;
la couche de transition à base de nitrure de bore et de titane (3b) présentant une teneur en bore croissante depuis la couche de nitrure de titane (3a) vers la couche de diborure de titane (3c), **caractérisé en ce que** la teneur en bore de la couche de transition à base de nitrure de bore et de titane (3b) ne dépasse pas 15% en atome.

2. Outil revêtu selon la revendication 1, la couche de transition à base de nitrure de bore et de titane (3b) présentant une épaisseur de couche de 0,1-4,0 µm, de préférence de 0,2-2,0 µm.

3. Outil revêtu selon la revendication 1 ou 2, la teneur en bore de la couche de transition à base de nitrure de bore et de titane (3b) augmentant de façon étagée.

4. Outil revêtu selon l'une quelconque des revendications précédentes, la couche de nitrure de titane (3a) présentant une épaisseur de couche de 0,1-2,0 µm, de préférence de 0,3-1,5 µm.

5. Outil revêtu selon l'une quelconque des revendications précédentes, la couche de diborure de titane (3c) présentant une épaisseur de couche de 0,2-15,0 µm, de préférence de 1,0-10,0 µm.

6. Outil (1) revêtu selon l'une quelconque des revendications précédentes, la couche de diborure de titane (3c) présentant des contraintes de compression internes dans une plage de -2,5 ± 2 GPa.

7. Outil revêtu selon l'une quelconque des revendications précédentes, la couche de diborure de titane (3c) présentant une dureté d'au moins 40 GPa.

8. Outil revêtu selon l'une quelconque des revendications précédentes, l'outil revêtu (1) étant un outil d'usinage avec élimination de copeaux pour des alliages à base de titane et/ou d'autres alliages non-ferreux.

9. Outil revêtu selon l'une quelconque des revendications précédentes, le substrat (2) étant un métal dur présentant une phase en matériau dur (4), principalement constituée de carbure de tungstène, et une phase de liant (5) dont le constituant principal est le cobalt.

10. Outil revêtu selon la revendication 9, la phase de liant (5) représentant 5-17% en poids du métal dur.

11. Outil revêtu selon la revendication 9 ou 10, la phase de liant (5) présentant une proportion de ruthénium de 6-16% en poids par rapport à la phase de liant.

12. Outil revêtu selon l'une quelconque des revendications précédentes, une interface du substrat (2) vers le revêtement de matériau dur (3) étant exempte d'une phase η et pratiquement exempte de bore.

13. Outil revêtu selon l'une quelconque des revendications précédentes, une couche de recouvrement étant formée sur la couche de diborure de titane (3c).

14. Outil revêtu selon l'une quelconque des revendications précédentes, la couche de transition de nitrure de bore et de titane (3b) présentant en continu une structure cristalline cubique.

15. Outil revêtu selon l'une quelconque des revendications précédentes, la couche de diborure de titane (3c) présentant une structure à grain fin présentant une grosseur moyenne des cristaux inférieure à 50 nm.

16. Utilisation d'un outil revêtu (1) selon l'une quelconque des revendications précédentes, pour un usinage avec élimination de copeaux d'alliages à base de titane et/ou d'autres alliages non-ferreux.
